(19) Europäisches Patentamt
European Patent Office
Office européen des brevets

(11) EP 2 543 705 A2

(12) # EUROPEAN PATENT APPLICATION

(43) Date of publication:
**09.01.2013 Bulletin 2013/02**

(21) Application number: **12175029.3**

(22) Date of filing: **05.07.2012**

(51) Int Cl.:
***C08L 63/00*** *(2006.01)* ***H01L 23/29*** *(2006.01)*
***C08G 59/62*** *(2006.01)* ***C08L 61/14*** *(2006.01)*
***C08K 3/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.07.2011 JP 2011149456**

(71) Applicant: **NITTO DENKO CORPORATION**
**Osaka (JP)**

(72) Inventors:
- **Kitagawa, Yuya**
  **Ibaraki-shi, Osaka (JP)**
- **Yamamoto, Mizuki**
  **Ibaraki-shi, Osaka (JP)**
- **Ono, Yuta**
  **Ibaraki-shi, Osaka (JP)**
- **Mizushima, Aya**
  **Ibaraki-shi, Osaka (JP)**
- **Hasegawa, Teruyoshi**
  **Ibaraki-shi, Osaka (JP)**

(74) Representative: **Grünecker, Kinkeldey, Stockmair & Schwanhäusser**
**Leopoldstrasse 4**
**80802 München (DE)**

(54) **Epoxy resin composition for electronic component encapsulation and electronic component device using the same**

(57) The present invention relates to an epoxy resin composition for electronic component encapsulation, including the following components (A) to (D): (A) an epoxy resin; (B) a curing agent: an allylated phenol resin containing a structural unit (1) shown below and a structural unit (2) shown below, in which a molar ratio [structural unit (1)/[structural unit (1)+structural unit (2)]×100] of the structural unit (1) to a total amount of the structural unit (1) and the structural unit (2) is from 40 to 100%; (C) a curing accelerator; and (D) an inorganic filler, in which the allylated phenol resin as the component (B) has a glass transition temperature of -5°C to 70°C as measured by a differential scanning calorimetry (DSC) method:

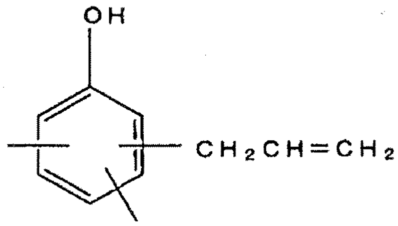

··· (1)

,

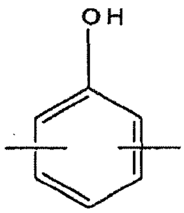

··· (2)

.



Printed by Jouve, 75001 PARIS (FR)

## Description

FIELD OF THE INVENTION

The present invention relates to an epoxy resin composition for electronic component encapsulation, which is used for encapsulating a semiconductor element and the like, and an electronic component device using the composition.

BACKGROUND OF THE INVENTION

Conventionally, in view of protecting a semiconductor element from the external environment and making its handling easy, a semiconductor device has been fabricated by encapsulating various semiconductor elements such as transistor, IC and LSI in a ceramic package, a plastic package or the like. The former ceramic package is advantageous in that since the constituent material itself has heat resistance and also has excellent humidity resistance, the package is durable even in a high-temperature high-humidity atmosphere and excellent in the mechanical strength and can realize highly reliable encapsulation.

However, the ceramic package has a problem that the constituent material is relatively expensive and the mass productivity thereof is poor. For this reason, resin encapsulation in the latter plastic package is recently predominating. For the resin encapsulation in the plastic package, an epoxy resin composition has been conventionally used by utilizing its property of excellent heat resistance and achieved good results.

As such an epoxy resin composition for encapsulating a semiconductor element, constituent components including, for example, an epoxy resin as a main member, a phenol resin as a curing agent, an amine-based compound as a curing accelerator, and other optional components such as rubber component as an elasticity imparting agent and silica powder as an inorganic filler, are generally used as a composition excellent particularly in the encapsulation workability and the like at the transfer molding.

On the other hand, there have been reported various insulating materials such as a semiconductor encapsulating material using an allyl group-containing phenol resin as a curing agent, but these are insufficient in the heat resistance, and a material satisfying the heat resistance is not yet obtained at present.

The above-described insulating material such as semiconductor encapsulating material containing an allyl group-containing phenol resin includes, for example, those aiming at enhancing the adhesiveness (see, Patent Document 1), those improved in the moisture absorption resistance (see, Patent Documents 2 and 3), those for decreasing the melt viscosity of a thermosetting resin composition (see, Patent Document 4), those improved in the laser marking property (see, Patent Document 5), and those having low thermal expansion property (see, Patent Document 6). Such insulating materials exhibit good characteristics for respective characteristics, but with respect to enhancement of the heat resistance, a sufficient property is not obtained. Also, as an example succeeded in enhancing the heat resistance, a thermosetting resin composition containing an allyl group-containing phenol resin and a bismaleimide compound has been proposed (see, Patent Document 7). However, in terms of molding, the thermosetting resin composition containing a bismaleimide compound is poor in the reactivity as compared with the curing reaction of an epoxy resin-phenol resin system generally known as an encapsulating material and disadvantageously lacks the workability. Furthermore, those increased in the glass transition temperature by using a thermosetting resin composition containing an allyl group-containing phenol resin and an epoxy resin have been proposed (see, Patent Documents 8 to 11), but in all cases, the post-curing temperature is 200°C or less and therefore, the allyl group is not cured, failing in enhancing the heat resistance. That is, the allyl group requires a temperature higher than 200°C for its thermal curing and is very low in the reactivity and on this account, it has not been studied to enhance the heat resistance by positively curing the allyl group.

Patent Document 1: JP-A-8-306828

Patent Document 2: JP-A-7-145300

Patent Document 3: JP-A-7-118367

Patent Document 4: JP-A-9-31167

Patent Document 5: JP-A-4-249526

Patent Document 6: JP-A-6-263841

Patent Document 7: JP-A-3-237126

Patent Document 8: JP-A-2001-11161

Patent Document 9: JP-A-5-132539

Patent Document 10: JP-A-5-320317

Patent Document 11: JP-A-6-136093

SUMMARY OF THE INVENTION

By the way, the semiconductor device for performing high power control or the like in major appliances or industrial instruments includes, for example, a power device such as transistor, diode and thyristor. In such a power device, replacement of an Si element by an SiC element or a GaN element is being studied so as to greatly decrease the loss in an electric power converter. Replacement by an SiC element or a GaN element makes it possible to increase the capacity, but this is considered to let the semiconductor element be exposed to a high voltage and generate as very high heat as 200 to 250°C, and when heat resistance of the encapsulating resin is poor, there is a high possibility of incurring damage or breakage of the package or semiconductor element.

Under these circumstances, addition of silicone oil or a rubber component into the encapsulating resin composition may be considered as the method for enhancing the heat resistance of the encapsulating resin, but such an additive component may bleed out to the interface between a lead frame and the encapsulating resin, giving rise to a problem that the adhesive force at the interface tends to decrease.

On the other hand, as the molding method for encapsulating a semiconductor element, there are various molding methods such as screen printing or dispense molding using a liquid encapsulating resin material, transfer molding, sheet molding and compression molding, but whichever molding method is used, fluidity and curability are required of the thermosetting resin composition to bean encapsulating material.

Of these thermosetting resin compositions, some compositions may have high heat resistance but tend to exhibit bad moldability, because the reaction rate is low and a curing failure occurs. Also, some resin compositions generate a by-product such as gas at the thermosetting reaction. Accordingly, in the case of using such a resin composition for semiconductor encapsulating material applications, a by-product such as gas is generated during molding to form a void or the like in the encapsulating resin, and this causes a problem that the reliability decreases, for example, a device failure occurs.

Under these circumstances, the present invention has been made, and an object of the present invention is to provide an epoxy resin composition for electronic component encapsulation, which is excellent in moldability such as fluidity and curability and at the same time, has a high glass transition temperature enough to exert an excellent effect in terms of heat resistance, and an electronic component device using the composition.

In order to attain the object above, the present invention relates to the following items 1 to 4.

1. An epoxy resin composition for electronic component encapsulation, including the following components (A) to (D):

(A) an epoxy resin;

(B) a curing agent: an allylated phenol resin containing a structural unit (1) shown below and a structural unit (2) shown below, in which a molar ratio [structural unit (1)/[structural unit (1)+structural unit (2)]×100] of the structural unit (1) to a total amount of the structural unit (1) and the structural unit (2) is from 40 to 100%:

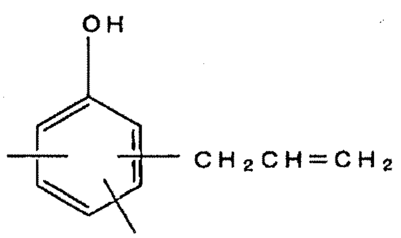

... (1)

,

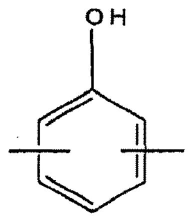 ··· (2)

;

(C) a curing accelerator; and
(D) an inorganic filler,
in which the allylated phenol resin as the component (B) has a glass transition temperature of -5°C to 70°C as measured by a differential scanning calorimetry (DSC) method.

2. The epoxy resin composition for electronic component encapsulation according to item 1, in which a blending ratio of the component (A) and the component (B) is set such that an epoxy equivalent of the component (A) becomes from 0.5 to 3.0 per one equivalent of a phenolic hydroxyl group of the component (B).
3. The epoxy resin composition for electronic component encapsulation according to item 1 or 2, in which in the allylated phenol resin as the component (B), the molar ratio [structural unit (1)/[structural unit (1)+structural unit (2)] ×100] of the structural unit (1) to the total amount of the structural unit (1) and the structural unit (2) is from 80 to 100%.

4. An electronic component device obtained by resin-encapsulating an electronic component with the epoxy resin composition for electronic component encapsulation according to any one of items 1 to 3.
The present inventors have made a great deal of intensive studies to obtain an encapsulating material excellent in the heat resistance without incurring reduction of moldability. As a result, it has been found that when an allylated phenol resin having a glass transition temperature in the above-described specific range (component (B)), with the allylation ratio of the allylated phenol resin (component (B)), that is, the molar ratio [structural unit (1)/[structural unit (1) +structural unit (2)]×100] of the structural unit (1) to the total amount of the structural unit (1) and the structural unit (2), being from 40 to 100%, is used, a low-viscosity encapsulating resin composition having a high glass transition temperature and in turn, being excellent in the heat resistance is obtained. The present invention has been accomplished based on this finding.
In this way, the present invention is an epoxy resin composition for electronic component encapsulation, containing, as a curing agent, an allylated phenol resin (component (B)) having a glass transition temperature in a specific range, in which the ratio of the structural unit (1) is in a specific range. Therefore, an encapsulating material that is excellent in moldability such as fluidity and curability and at the same time, has a high glass transition temperature enough to exert an excellent effect in terms of heat resistance, can be obtained. In turn, an electronic component device obtained by using the epoxy resin composition for electronic component encapsulation can have characteristics such as high heat resistance and reliability.
Also, when the blending ratio between the epoxy resin (component (A)) and the specific allylated phenol resin (component (B)) is set such that the epoxy equivalent of the component (A) becomes from 0.5 to 3.0 per one equivalent of the phenolic hydroxyl group of the component (B), this is more effective in terms of enhancing the reactivity.

DETAILED DESCRIPTION OF THE INVENTION

The mode for carrying out the present invention is described below.
The epoxy resin composition for electronic component encapsulation (hereinafter, sometimes simply referred to as the "epoxy resin composition") of the present invention is obtained using an epoxy resin (component (A)), a specific allylated phenol resin (component (B)), a curing accelerator (component (C)) and an inorganic filler (component (D)) and is usually in the form of a powder or a tablet obtained by tabletting the powder.

<Epoxy Resin>

As the epoxy resin (component (A)), a polyfunctional epoxy resin is preferably used, and examples thereof include a phenol novolak-type epoxy resin, a cresol novolak-type epoxy resin, a triphenylmethane-type epoxy resin, a diphenylmethane-type epoxy resin, a furan ring-containing dicyclopentadiene novolak-type epoxy resin, and a naphthalenediol-type epoxy resin. One of these is used alone, or two or more thereof are used in combination. Among these epoxy resins, in view of heat resistance, a triphenylmethane-type epoxy resin and a naphthalenediol-type epoxy resin are preferably used.

The epoxy equivalent of the epoxy resin (component (A)) is preferably from 100 to 3,000 equivalents (g/eq.), more preferably from 100 to 1,000 equivalents (g/eq.), still more preferably from 100 to 500 equivalents (g/eq.). That is, if the epoxy equivalent is too small and is outside the range above, the elongation at breakage can be hardly increased, maybe due to a high density of crosslinking sites of the cured product obtained and this is not preferred, whereas if the epoxy equivalent too large and is outside the range above, curability tends to be impaired.

The content of the epoxy resin (component (A)) is preferably from 3 to 15 wt%, more preferably from 5 to 10 wt%, based on the entire epoxy resin composition for electronic component encapsulation. Because, if the content of the epoxy resin (component (A)) is outside the range above, the linear expansion coefficient of the epoxy resin composition for electronic component encapsulation is less likely to fall in an appropriate range.

<Specific Allylated Phenol Resin>

The specific allylated phenol resin (component (B)) used together with the epoxy resin (component (A)) is a curing agent acting to cure the epoxy resin (component (A)) and is a phenol resin containing a structural unit (1) shown below and a structural unit (2) shown below.

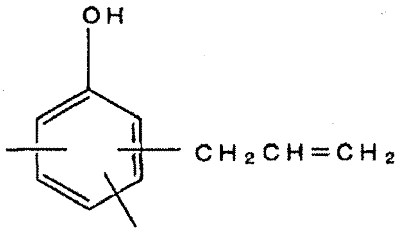

··· (1)

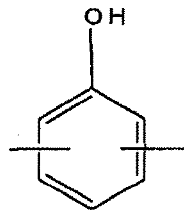

··· (2)

In the allylated phenol resin (component (B)), the molar ratio [structural unit (1)/[structural unit (1)+structural unit (2)]×100] of the structural unit (1) to the total amount of the structural unit (1) and the structural unit (2) must be from 40 to 100%. The molar ratio is more preferably from 80 to 100%. The molar ratio [structural unit (1)/[structural unit (1)+structural unit (2)]×100] of the structural unit (1) to the total amount of the structural unit (1) and the structural unit (2) is also called as "an allylation ratio", and the allylation ratio must be from 40 to 100% and is preferably from 80 to 100%. That is, if the allylation ratio is too small and is outside the range above, the cured product obtained is decreased in the glass transition temperature and in turn, becomes poor in the heat resistance.

In the allylated phenol resin (component (B)), the glass transition temperature as measured by a differential scanning calorimetry (DSC) method must be from -5°C to 70°C. Because, if the glass transition temperature is too low and is outside the range above, blocking property of the obtained epoxy resin composition becomes bad, whereas if the glass transition temperature is too high and is outside the range above, the obtained epoxy resin composition comes to have high viscosity. Incidentally, as for the glass transition temperature as measured by a differential scanning calorimetry (DSC) method, for example, differential scanning calorimetry is performed in accordance with "Method for Measuring Transition Temperature of Plastics" of JIS K7121 (enacted in 1987), and the midpoint glass transition temperature in the measurement is taken as the glass transition temperature of the allylated phenol resin. Specifically, about 10 mg of an allylated phenol resin (component (B)) to be measured is weighted in an aluminum pan and tightly closed, and the glass transition temperature can be measured and calculated by using a differential scanning calorimetry apparatus (DSC6200, manufactured by SII NanoTechnology Inc.).

The allylated phenol resin (component (B)) can be synthesized, for example, as follows. That is, a phenol novolak resin, an allyl halide, a basic compound and a solvent are mixed and stirred under heating to obtain an allyletherified phenol resin. Subsequently, this allyletherified phenol resin is heated at 180 to 200°C to let a part or the whole of allyl groups of the allyletherified phenol resin undergo Claisen rearrangement, whereby the target allylated phenol

resin (component (B)) can be synthesized. The allylated phenol resin obtained by such a synthesis is an allylated phenol resin containing the structural unit (1) and the structural unit (2), as described above.

In order to obtain an allylated phenol resin (component (B)) having the above-described allylation ratio, in which the glass transition temperature by the DSC method is in a specific range, it may be sufficient if the amounts of allyl halide and basic compound are adjusted at the synthesis, and as for the glass transition temperature, adjustment can be also achieved by adjusting the molecular weight of the phenol novolak resin used. Specifically, the target specific allylation ratio may be attained by adding the allyl halide to account for one to two equivalents based on the hydroxyl group equivalent of the phenol novolak resin. Also, the basic compound may be added to account for one to two equivalents based on the hydroxyl group equivalent of the phenol novolak resin. The glass transition temperature can be controlled, even with the same allylation ratio, by adjusting the molecular weight of the phenol novolak resin as described above. For example, in an allylated phenol resin (component (B)) having an allylation ratio of 100%, with respect to the weight average molecular weight and glass transition temperature that are measured and calculated by the method described above or later, the glass transition temperature is -28°C when the weight average molecular weight is 599, the glass transition temperature is -5°C when the weight average molecular weight is 2,866, and the glass transition temperature is 13°C when the weight average molecular weight is 3,647. In this way, the glass transition temperature rises due to increase in the molecular weight of the allylated phenol resin (component (B)) and therefore, the glass transition temperature can be controlled by adjusting the weight average molecular weight.

Incidentally, the weight average molecular weight of the allylated phenol resin is measured and calculated, for example, as follows. That is, a 0.1% tetrahydrofuran (THF) solution of the allylated phenol resin is prepared and left standing at 25°C for 1 day. Thereafter, the solution is filtered through a 0.45-μm membrane filter, and the obtained filtrate is subjected to molecular weight measurement. In the molecular weight measurement, for example, GPC (HLC-8120GPC, manufactured by Tosoh Corporation, column: $GMH_{XL}$, $GMH_{XL}$ and $G3000H_{XL}$, manufactured by Tosoh Corporation) is used. Also, in this case, the measurement conditions are a column temperature of 40°C, an eluent of tetrahydrofuran, a flow velocity of 0.8 mL/min, and an injection amount of 100 μL. Using a differential refractometer as the detector, the number average molecular weight (Mn) as well as the weight average molecular weight (Mw) are calculated in terms of polystyrene.

The allylated phenol resin (component (B)) having the target specific allylation ratio, in which the glass transition temperature by the DSC method is in a specific range, can be similarly synthesized also by mixing ortho-allylphenol and formalin, adding an acid catalyst thereto, and stirring the mixture under heating. In this case, as for adjustment of the allylation ratio, for example, the ortho-allylphenol and formalin are mixed in an arbitrary ratio and polymerized, whereby the allylation ratio can be adjusted to the target allylation ratio. Also, in this case, the glass transition temperature can be controlled by adjusting the weight average molecular weight, as described above.

In view of reactivity, the blending ratio of component (A) and component (B) is preferably set such that the epoxy equivalent of the component (A) becomes from 0.5 to 3.0 per one equivalent of the phenolic hydroxyl group in the component (B). Furthermore, in view of the reactivity above, the epoxy equivalent is more preferably from 0.6 to 2.0 equivalents, still more preferably from 0.8 to 1.5 equivalents.

In addition, a phenol resin other than the allylated phenol resin (component (B)) may be used as a curing agent component for the epoxy resin (component (A)) as long as it does not inhibit the curing of the present invention. Examples of this phenol resin include various phenol resins such as dicyclopentadiene-type phenol resin, phenol novolak resin, cresol novolak resin and phenol aralkyl resin. One of these phenol resins is used alone, or two or more thereof are used in combination. In the case of using a phenol resin other than the allylated phenol resin (component (B)), specifically, the resin is preferably designed to account for 60 wt% or less based on the entire phenol resin component (curing agent component) including the component (B).

<Curing Accelerator>

Specific examples of the curing accelerator (component (C)) used together with the component (A) and the component (B) include an organic phosphorus-based accelerator such as tetraphenylphosphonium · tetraphenylborate and triphenylphosphine, an imidazole-based curing accelerator such as 2-methylimidazole and phenylimidazole, a tertiary amine-based curing accelerator such as 1,8-diazabicyclo(5.4.0)undecene-7 and 1,5-diazabicyclo(4.3.0)nonene-5, a boron-based curing accelerator, and a phosphorus-boron-based curing accelerator. One of these curing accelerators is used alone, or two or more thereof are used in combination. Among these, in view of versatility and cost in the market, an organic phosphorus-based curing accelerator and an imidazole-based curing agent are preferably used.

The content of the curing accelerator (component (C)) is preferably set to be from 0.001 to 10 wt%, more preferably from 0.05 to 5 wt%, based on the total amount of the component (A) and the component (B). Because, if the content of the curing accelerator is too small, the curability tends to be impaired, whereas if the content of the curing accelerator is too large, this is likely to lead to deterioration of the electrical characteristics or reduction in the heat resistance.

<Inorganic Filler>

Examples of the inorganic filler (component (D)) used together with the components (A) to (C) include quartz glass, talc, and various powders such as silica powder (e.g., fused silica powder, crystalline silica powder), alumina powder, aluminum nitride powder and silicon nitride powder. The inorganic filler which can be used may be in any of, for example, crushed, spherical and ground forms. One of these inorganic fillers is used alone, or two or more thereof are used in combination. Above all, a silica powder is preferably used in terms of the fact that the internal stress is reduced due to decrease in the thermal linear expansion coefficient of the cured material of the epoxy resin composition obtained and in turn, the substrate after encapsulation can be prevented from warpage, and among silica powders, in view of high filling property and high fluidity, it is more preferred to use a fused silica powder. The fused silica powder includes a spherical fused silica powder and a crushed fused silica powder, and in view of the fluidity, use of a spherical fused silica powder is preferred.

The average particle diameter of the inorganic filler (component (D)) is preferably from 1 to 30 $\mu$m, more preferably from 2 to 20 $\mu$m. The average particle diameter of the inorganic filler (component (D)) can be measured, for example, by using a commercially available laser diffraction/scattering particle size distribution analyzer after taking out an arbitrary measurement sample from the parent population.

The content of the inorganic filler (component (D)) is preferably set to a range of 70 to 90 wt%, more preferably from 80 to 90 wt%, based on the entire epoxy resin composition. Because, if the content of the inorganic filler (component (D)) is too small, the thermal linear expansion coefficient of the cured material of the epoxy resin composition becomes large and in turn, warpage of the cured material tends to be increased, whereas if the content of the inorganic filler (component (D)) is too large, the fluidity of the epoxy resin composition is reduced, and this is liable to cause reduction in the adhesiveness to an electronic component or a substrate.

<Various Additives>

In the epoxy resin composition of the present invention, various additives can be blended, if desired, in addition to the components (A) to (D), as long as the functions of the epoxy resin composition are not impaired. Examples of the additive include an adhesiveness-imparting agent, an electrical conductivity-imparting agent as an electrostatic countermeasure, a flame retardant, an ion scavenger, an antioxidant, a low stress agent, a release agent, a fluidity-imparting agent, a moisture absorbent, a colorant, and a pigment.

Examples of the release agent include a compound such as higher aliphatic acid, higher aliphatic acid ester and higher aliphatic acid calcium, and, for example, a carnauba wax and a polyethylene oxide-based wax are used. One of these is used alone, or two or more thereof are used in combination.

Examples of the flame retardant include an organic phosphorus-based compound, an antimony oxide, and a metal hydroxide such as aluminum hydroxide and magnesium hydroxide. One of these is used alone, or two or more thereof are used in combination.

As the pigment, for example, carbon black having a destaticizing effect can be used.

In addition to those various additives, various coupling agents such as $\gamma$-mercaptopropyltrimethoxysilane can be appropriately used.

<Curing of Epoxy Resin Composition>

The epoxy resin composition of the present invention contains the above-described specific allylated phenol resin (component (B)) and therefore, at the time of resin-encapsulating an electronic component with the composition, it is preferred to positively cure the allyl group in the component (B). As such, in the epoxy resin composition containing the specific allylated phenol resin (component (B)), a curing reaction by epoxy-phenol curing takes place as a first-stage reaction step on heating at 100 to 200°C, and an allyl group resistant to thermal decomposition is cured as a second-stage reaction step on heating at 220 to 350°C, whereby a cured product is obtained. In the present invention, thermal decomposition of the cured product is inhibited by the curing reaction of the allyl group and in turn, enhancement of the glass transition temperature is realized.

In the case of producing a cured product of the epoxy resin composition of the present invention, considering the moldability in molding such as transfer molding, sheet molding, compression molding, screen molding and dispense molding, the reaction is preferably performed at a temperature of 100 to 200°C, more preferably from 150 to 200°C, so as to effect pre-curing. Also, the reaction time on heating at the temperature above is from 1 to 60 minutes, preferably for 1 to 30 minutes, more preferably from 1 to 10 minutes. Subsequently, heating at 100 to 200°C for 2 to 6 hours is performed as post-curing. Furthermore, in order to accelerate the curing reaction of the allyl group, after performing the reaction under the above-described reaction conditions, heating is performed at 180 to 220°C for 10 to 3,000 minutes and further at 220 to 350°C for 10 to 6,000 minutes, preferably at 220 to 300°C for 10 to 1,440 minutes, whereby thermal

decomposition can be inhibited and a cured product having a high glass transition temperature can be obtained. If the temperature region is too low and is outside the range above, the reaction of the allyl group can hardly proceed sufficiently, and this may disadvantageously give rise to an adverse effect on the heat resistance and enhancement of the glass transition temperature, whereas if the temperature is too high and is outside the range above, there may be led to reduction in the heat resistance due to thermal decomposition of the cured product obtained. Also, in the use environment at a high temperature (200 to 250°C) of a device obtained by resin encapsulation, the reaction of the allyl group in the component (B) is allowed to gradually proceed, so that even when the structure of the cured product obtained by curing the epoxy resin composition of the present invention under long-term high-temperature conditions is partially cut off, the crosslinking can be repaired and long-term heat resistance can be imparted.

The cured product obtained through a curing reaction by using the epoxy resin composition of the present invention is excellent particularly in the heat resistance and therefore, is suitably used for various electronic components, for example, an electronic material such as printed wiring board laminate, printed wiring board and semiconductor-mounted module, in addition to the semiconductor encapsulating material.

## EXAMPLES

In the following, Examples are described together with Comparative Examples. However, the present invention is not limited to these Examples. In Examples and Comparative Examples, unless otherwise indicated, "parts" and "%" are on the weight basis.

In advance of the production of an epoxy resin composition, an allylated phenol resin was synthesized (Synthesis Examples B-1 to B-8).

[Synthesis Example B-1: Synthesis of Allylated Phenol Resin (APN-1)]

105 Parts of phenol novolak resin (GS-180, produced by Gun Ei Chemical Industry Co., Ltd., hydroxyl group equivalent: 105 g/eq.), 181.5 parts of allyl bromide (produced by Tokyo Chemical Industry Co., Ltd.), 207.3 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 100% was obtained. This allyletherified phenol resin was heated with stirring at 200°C for 24 hours in a nitrogen atmosphere to obtain the target allylated phenol resin (APN-1) having a Claisen rearrangement ratio of 100%.

[Synthesis Example B-2: Synthesis of Allylated Phenol Resin (APN-2)]

105 Parts of phenol novolak resin (GS-180, produced by Gun Ei Chemical Industry Co., Ltd., hydroxyl group equivalent: 105 g/eq.), 121.0 parts of allyl bromide (produced by Tokyo Chemical Industry Co., Ltd.), 138.2 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 82% was obtained. This allyletherified phenol resin was heated with stirring at 200°C for 24 hours in a nitrogen atmosphere to obtain the target allylated phenol resin (APN-2) having a Claisen rearrangement ratio of 100%.

[Synthesis Example B-3: Synthesis of Allylated Phenol Resin (APN-3)]

105 Parts of phenol novolak resin (GS-180, produced by Gun Ei Chemical Industry Co., Ltd., hydroxyl group equivalent: 105 g/eq.), 90.7 parts of allyl bromide (produced by Tokyo Chemical Industry Co., Ltd.), 138.2 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After

cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 63% was obtained. This allyletherified phenol resin was heated with stirring at 200°C for 24 hours in a nitrogen atmosphere to obtain the target allylated phenol resin (APN-3) having a Claisen rearrangement ratio of 100%.

[Synthesis Example B-4: Synthesis of Allylated Phenol Resin (APN-4)]

105 Parts of phenol novolak resin (GS-180, produced by Gun Ei Chemical Industry Co., Ltd., hydroxyl group equivalent: 105 g/eq.), 60.5 parts of allyl bromide (produced by Tokyo Chemical Industry Co., Ltd.), 103.7 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 44% was obtained. This allyletherified phenol resin was heated with stirring at 200°C for 24 hours in a nitrogen atmosphere to obtain the target allylated phenol resin (APN-4) having a Claisen rearrangement ratio of 100%.

[Synthesis Example B-5: Synthesis of Allylated Phenol Resin (APN-5)]

105 Parts of phenol novolak resin (GS-180, produced by Gun Ei Chemical Industry Co., Ltd., hydroxyl group equivalent: 105 g/eq.), 30.3 parts of allyl bromide (produced by Tokyo Chemical Industry Co., Ltd.), 69.1 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 20% was obtained. This allyletherified phenol resin was heated with stirring at 200°C for 24 hours in a nitrogen atmosphere to obtain the target allylated phenol resin (APN-5) having a Claisen rearrangement ratio of 100%.

[Synthesis Example B-6: Synthesis of Allylated Phenol Resin (APN-6)]

105 Parts of phenol novolak resin (GS-200, produced by Gun Ei Chemical Industry Co., Ltd., hydroxyl group equivalent: 105 g/eq.), 181.5 parts of allyl bromide (produced by Tokyo Chemical Industry Co., Ltd.), 207.3 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 100% was obtained. This allyletherified phenol resin was heated with stirring at 200°C for 24 hours in a nitrogen atmosphere to obtain the target allylated phenol resin (APN-6) having a Claisen rearrangement ratio of 100%.

[Synthesis Example B-7: Synthesis of Allylated Phenol Resin (APN-7)]

105 Parts of phenol novolak resin (HF-3M, produced by Meiwa Plastic Industries, Ltd., hydroxyl group equivalent: 105 g/eq.), 181.5 parts of allyl bromide (produced by Tokyo Chemical Industry Co., Ltd.), 207.3 parts of potassium

carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 100% was obtained. This allyletherified phenol resin was heated with stirring at 200°C for 24 hours in a nitrogen atmosphere to obtain the target allylated phenol resin (APN-7) having a Claisen rearrangement ratio of 100%.

[Synthesis Example B-8: Synthesis of Allylated Phenol Resin (APN-8)]

105 Parts of phenol novolak resin (HF-4M, produced by Meiwa Plastic Industries, Ltd., hydroxyl group equivalent: 105 g/eq.), 181.5 parts of allyl bromide (produced by Tokyo Chemical Industry Co., Ltd.), 207.3 parts of potassium carbonate (produced by Wako Pure Chemical Industries, Ltd.) and 500 parts of acetone (produced by Wako Pure Chemical Industries, Ltd.) were mixed and refluxed under heating for 24 hours in a nitrogen gas stream. After cooling to room temperature, filtration and concentration were performed, and the residue was added with 400 parts of ethyl acetate (produced by Wako Pure Chemical Industries, Ltd.), then washed once with 200 parts of hydrochloric acid (produced by Wako Pure Chemical Industries, Ltd.) adjusted to 5% by dilution with distilled water, and further washed twice each with 200 parts of distilled water. Thereafter, the organic layer was extracted, dried over magnesium sulfate (produced by Wako Pure Chemical Industries, Ltd.), and then subjected to filtration and concentration, whereby an allyletherified phenol resin having an allylation ratio of 100% was obtained. This allyletherified phenol resin was heated with stirring at 200°C for 24 hours in a nitrogen atmosphere to obtain the target allylated phenol resin (APN-8) having a Claisen rearrangement ratio of 100%.

On the other hand, a commercially available allylated phenol resin [B-9 (APN-9)] was prepared.

[B-9: Allylated Phenol Resin (APN-9)]

Hydroxyl group equivalent: 146, allylation ratio: 100% (XPL-4437E, produced by Gun Ei Chemical Industry Co., Ltd.)

In addition to the allylated phenol resin above, the following components were prepared.

[Phenol Novolak Resin]

Hydroxyl group equivalent: 105 (GS-180, produced by Gun Ei Chemical Industry Co., Ltd.)

[Epoxy Resin]

Triphenolmethane-type epoxy resin (epoxy equivalent: 170, EPPN-501HY, produced by Nippon Kayaku Co., Ltd.)

[Inorganic Filler]

Fused spherical silica powder (average particle diameter: 20 μm)

[Curing Accelerator]

Triphenylphosphine (TPP, produced by Tokyo Chemical Industry Co., Ltd.)

[Release Agent]

Polyethylene oxide wax (acid value: 17, PED521 produced by Hoechst Ltd.)

[Pigment]

Carbon black

[Coupling Agent]

γ-Mercaptopropyltrimethoxysilane (KBM-803 produced by Shin-Etsu Chemical Co., Ltd.)

[Measurements of Physical Properties of Allylated Phenol Resins B-1 to B-9]

Physical properties of Allylated Phenol Resins B-1 to B-9 (APN-1 to APN-9) obtained above were measured and evaluated according to the following methods. The results obtained are shown in Table 1.

[Molecular Weight]

A 0.1% tetrahydrofuran (THF) solution of each of Allylated Phenol Resins B-1 to B-9 (APN-1 to APN-9) was prepared and left standing at 25°C for 1 day. Thereafter, the solution was filtered through a 0.45-μm membrane filter, and the obtained filtrate was subjected to molecular weight measurement. The apparatus used for the molecular weight measurement was GPC (HLC-8120GPC, manufactured by Tosoh Corporation, column: $GMH_{XL}$, $GMH_{XL}$ and $G3000H_{XL}$, manufactured by Tosoh Corporation). Also, the measurement conditions were a column temperature of 40°C, an eluent of tetrahydrofuran, a flow velocity of 0.8 mL/min, and an injection amount of 100 μL. Using a differential refractometer as the detector, the number average molecular weight (Mn), the weight average molecular weight (Mw), each in terms of polystyrene, and the ratio between these two molecular weights [weight average molecular weight (Mw)/number average molecular weight (Mn)] were calculated.

[Allylation Ratio]

Peak integration values of the carbon (CB) on a benzene ring bonded to a hydroxyl group and an allyl ether and the carbon (CA) of a methylene group of an allyl group, as determined by the $^{13}$C-NMR spectrum method using an inverse gated-decoupling method, were substituted into the following formula to calculate the allylation ratio:

$$\text{Allylation ratio (\%)} = (CA)/(CB) \times 100$$

[Glass Transition Temperature of Allylated Phenol Resin]

Differential scanning calorimetry was performed in accordance with "Method for Measuring Transition Temperature of Plastics" of JIS K7121 (enacted in 1987), and the midpoint glass transition temperature was taken as the glass transition temperature of the allylated phenol resin. Specifically, about 10 mg of the allylated phenol resin above was weighted in an aluminum pan and tightly closed, and the glass transition temperature was calculated by using a differential scanning calorimetry apparatus (DSC6200, manufactured by SII NanoTechnology Inc.).

[Table 1]

| | | Allylated Phenol Resin | | | | | | | | | Phenol Novolak Resin (PN-1) |
|---|---|---|---|---|---|---|---|---|---|---|---|
| | | B-1 (APN-1) | B-2 (APN-2) | B-3 (APN-3) | B-4 (APN-4) | B-5 (APN-1) | B-6 (APN-2) | B-7 (APN-1) | B-8 (APN-2) | B-9 (APN-3) | |
| Allylation ratio (%) | | 100 | 82 | 63 | 44 | 20 | 100 | 100 | 100 | 100 | 0 |
| Glass transition temperature (°C) | | -5 | 5 | 14 | 21 | 29 | 13 | 70 | 79 | -28 | 35 |
| Molecular weight | Number average molecular weight (Mn) | 846 | 811 | 797 | 678 | 557 | 1105 | 1905 | 2205 | 439 | 426 |
| | Weight average molecular weight (Mw) | 2866 | 2566 | 2003 | 1556 | 1222 | 3647 | 6477 | 7718 | 599 | 731 |
| | Mw/Mn Ratio | 3.4 | 3.0 | 2.5 | 2.3 | 2.2 | 3.3 | 3.4 | 3.5 | 1.4 | 1.7 |

[Examples 1 to 6 and Comparative Examples 1 to 4]

Respective components shown in Tables 2 and 3 later were blended in the ratio shown in the same Tables at ordinary temperature and melt-kneaded over 5 minutes in a roll kneader heated to 80 to 120°C to obtain a melt mixture. This melt was cooled, and the resulting solid was pulverized into a powder form to produce an epoxy resin composition.
Using the thus-obtained epoxy resin compositions of Examples and Comparative Examples, the characteristics were measured and evaluated according to the following methods. The results are shown together in Tables 2 and 3 later.

[Blocking Property]

The epoxy resin composition obtained was applied with a load of 10 g/$cm^2$ for 24 hours in an environment of 22°C×relative humidity of 70% and then sieved 50 times through a 2 mm-mesh sieve, and the percentage (%) of the material remaining on the 2 mm-mesh sieve was measured and calculated.
The blocking property of the epoxy resin composition was evaluated based on the following criteria:

A: less than 10%
B: 10% or more

[Glass Transition Temperature of Epoxy Resin Composition]

Using the obtained epoxy resin composition, a cured product (20 mm (length)x3 mm (width)x3 mm (thickness)) was produced by transfer molding (175°Cx3 minutes), and this cured product was post-cured (175°Cx5 hours, then 200°Cx5 hours, and finally 250°C×10 hours) to produce a test piece. The test piece was measured at a temperature rise rate of 5°C/min by using a TMA apparatus (Model No. MG800GM) manufactured by Rigaku Corporation to determine the glass transition temperature as well as the linear expansion coefficient.
Whether good or bad in terms of the glass transition temperature of the epoxy resin composition was evaluated based on the following criteria:

A: 250°C or more
B: less than 250°C

[Viscosity]

Using the obtained epoxy resin composition, the minimum melt viscosity (Pa· s) at 175°C was determined by an elevated flow tester manufactured by Shimadzu Corporation.
Whether good or bad in terms of the viscosity of the epoxy resin composition was evaluated based on the following criteria:

A: less than 80 Pa· s
B: 80 Pa· s or more

[Table 2]

| | | | | | | (parts) |
|---|---|---|---|---|---|---|
| | Example | | | | | |
| | 1 | 2 | 3 | 4 | 5 | 6 |
| Epoxy resin (A) | 88.3 | 88.3 | 92.7 | 95.1 | 96.0 | 96.0 |

(continued)

| | | Example | | | | | |
|---|---|---|---|---|---|---|---|
| | | 1 | 2 | 3 | 4 | 5 | 6 |
| Allylated phenol resin (B) | B-1 | 7.97 | - | - | - | - | - |
| | B-2 | - | 7.97 | - | - | - | - |
| | B-3 | - | - | 7.51 | - | - | - |
| | B-4 | - | - | - | 7.27 | - | - |
| | B-5 | - | - | - | - | - | - |
| | B-6 | - | - | - | - | 7.17 | - |
| | B-7 | - | - | - | - | - | 7.17 |
| | B-8 | - | - | - | - | - | - |
| | B-9 | - | - | - | - | - | - |
| Phenol novolak resin | | - | - | - | - | - | - |
| Curing accelerator (C) | | 0.8 | 0.8 | 0.7 | 0.7 | 0.7 | 0.7 |
| Inorganic filler (D) | | 829.5 | 829.5 | 829.5 | 829.5 | 829.5 | 829.5 |
| Release agent | | 3.4 | 3.4 | 3.4 | 3.4 | 3.4 | 3.4 |
| Pigment | | 0.5 | 0.5 | 0.5 | 0.5 | 0.5 | 0.5 |
| Coupling agent | | 2.2 | 2.2 | 2.2 | 2.2 | 2.2 | 2.2 |
| Blocking property | Evaluation | A | A | A | A | A | A |
| | Percentage (%) | 0 | 0 | 0 | 0 | 0 | 0 |
| Glass transition temperature | Evaluation | A | A | A | A | A | A |
| | (°C) | 308 | 309 | 306 | 263 | 310 | 311 |
| Viscosity | Evaluation | A | A | A | A | A | A |
| | (Pa· s) | 12 | 13 | 15 | 18 | 29 | 70 |

[Table 3]

| | | | | (parts) |
|---|---|---|---|---|
| | Comparative Example | | | |
| | 1 | 2 | 3 | 4 |
| Epoxy resin (A) | 88.0 | 98.4 | 88.0 | 90.4 |

(continued)

| | | Comparative Example | | | |
|---|---|---|---|---|---|
| | | 1 | 2 | 3 | 4 |
| Allylated phenol resin (B) | B-1 | - | - | - | - |
| | B-2 | - | - | - | - |
| | B-3 | - | - | - | - |
| | B-4 | - | - | - | - |
| | B-5 | - | 6.92 | - | - |
| | B-6 | - | - | - | - |
| | B-7 | - | - | - | - |
| | B-8 | - | - | 8.00 | - |
| | B-9 | 8.00 | - | - | - |
| Phenol novolak resin | | - | - | - | 7.76 |
| Curing Accelerator (C) | | 0.8 | 0.7 | 0.8 | 0.7 |
| Inorganic filler (D) | | 829.5 | 829.5 | 829.5 | 829.5 |
| Release agent | | 3.4 | 3.4 | 3.4 | 3.4 |
| Pigment | | 0.5 | 0.5 | 0.5 | 0.5 |
| Coupling agent | | 2.2 | 2.2 | 2.2 | 2.2 |
| Blocking property | Evaluation | B | A | A | A |
| | Percentage (%) | 90 | 0 | 0 | 0 |
| Glass transition temperature | Evaluation | could not be produced* | B | A | B |
| | (°C) | | 215 | 315 | 201 |
| Viscosity | Evaluation | | A | B | A |
| | (Pa· s) | | 20 | 105 | 9 |
| * The measurement sample could not be produced and in turn, measurement and evaluation could not be performed. | | | | | |

It is seen from these results that in all of the products of Examples, the glass transition temperature is as high as exceeding 260°C and the heat resistance is excellent. Moreover, a very good result is obtained in terms of the blocking property and at the same time, the viscosity is low, revealing that fluidity at the molding is also excellent.

On the other hand, the product of Comparative Example 2 using an allylated phenol resin in which the glass transition temperature is in the specific range but the allylation ratio is low, the glass transition temperature is low and the heat resistance is poor, though good results are obtained in terms of blocking property and fluidity. Also, in the product of Comparative Example 3 using an allylated phenol resin in which the allylation ratio is 100% but the glass transition temperature is high and exceeds the specific range, the viscosity is high and the fluidity is poor, though the blocking property is good and the glass transition temperature is high, revealing excellent heat resistance. Furthermore, in the product of Comparative Example 4 using a resin in which the glass transition temperature is in the specific range but the allylation ratio is 0%, that is, a normal phenol novolak resin, the glass transition temperature is low and the heat resistance is poor, though good results are obtained in terms of blocking property and fluidity.

Incidentally, in Comparative Example 1, the mixture after kneading was liquid and therefore, could not be cooled and pulverized, thus failing in producing the epoxy resin composition for measurement, and the glass transition temperature and the viscosity could not be measured.

While the invention has been described in detail with reference to specific embodiments thereof, it will be apparent to one skilled in the art that various changes and modifications can be made therein without departing from the spirit and scope thereof.

Incidentally, the present application is based on Japanese Patent Application No. 2011-149456 filed on July 5, 2011,

and the contents are incorporated herein by reference.
All references cited herein are incorporated by reference herein in their entirety.

The epoxy resin composition for electronic component encapsulation of the present invention is useful as an encapsulating material, for example, in a power device such as transistor, diode and thyristor.

## Claims

1. An epoxy resin composition for electronic component encapsulation, comprising the following components (A) to (D):

   (A) an epoxy resin;
   (B) a curing agent: an allylated phenol resin containing a structural unit (1) shown below and a structural unit (2) shown below, in which a molar ratio [structural unit (1)/[structural unit (1)+structural unit (2)]×100] of the structural unit (1) to a total amount of the structural unit (1) and the structural unit (2) is from 40 to 100%:

   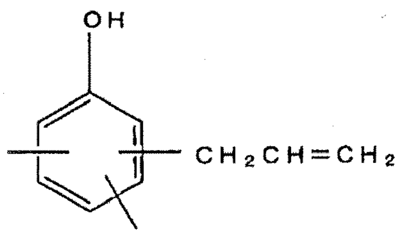
   ··· (1)

   ,

   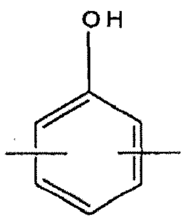
   ··· (2)

   ;

   (C) a curing accelerator; and
   (D) an inorganic filler,
   wherein the allylated phenol resin as the component (B) has a glass transition temperature of -5°C to 70°C as measured by a differential scanning calorimetry (DSC) method.

2. The epoxy resin composition for electronic component encapsulation according to claim 1, wherein a blending ratio of the component (A) and the component (B) is set such that an epoxy equivalent of the component (A) becomes from 0.5 to 3.0 per one equivalent of a phenolic hydroxyl group of the component (B).

3. The epoxy resin composition for electronic component encapsulation according to claim 1 or 2, wherein in the allylated phenol resin as the component (B), the molar ratio [structural unit (1)/[structural unit (1)+structural unit (2)]×100] of the structural unit (1) to the total amount of the structural unit (1) and the structural unit (2) is from 80 to 100%.

4. An electronic component device obtained by resin-encapsulating an electronic component with the epoxy resin composition for electronic component encapsulation according to any one of claims 1 to 3.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 8306828 A
- JP 7145300 A
- JP 7118367 A
- JP 9031167 A
- JP 4249526 A
- JP 6263841 A
- JP 3237126 A
- JP 2001011161 A
- JP 5132539 A
- JP 5320317 A
- JP 6136093 A
- JP 2011149456 A